# EUROPEAN PATENT APPLICATION

(11) **EP 3 082 160 A1**
(43) Date of publication of application: **19.10.2016**
(21) Application number: 14868920.1
(22) Date of filing: 06.11.2014
(51) Int. Cl.: H01L 23/485, H01L 23/488, H01L 21/60

(54) **SEMICONDUCTOR DEVICE AND MANUFACTURING METHOD THEREOF**

(30) Priority: 13.12.2013 CN 201310682785
(71) Applicant: Dynax Semiconductor, Inc., Kunshan, Jiangsu 215300 (CN)
(72) Inventor: ZHANG, Naiqian, Kunshan Jiangsu 215300 (CN); PEI, Fengli, Kunshan Jiangsu 215300 (CN)
(74) Representative: ABG Patentes, S.L.
(86) International application number: PCT/CN2014/090443
(87) International publication number: WO 2015/085841

(57) **Abstract**

A semiconductor device and a manufacturing method thereof are disclosed. The semiconductor device comprises: a substrate, a grounded electrode being disposed on a bottom surface of the substrate; a semiconductor layer located on an upper surface of the substrate, the semiconductor layer including an active region (5) and an inactive region, the active region (5) being in an enclosed form and the inactive region being outside the active region (5); source electrodes (11) and source electrode pads (13) disposed in the inactive region, the source electrode pads being directly electrically connected to the source electrodes, each of the source electrodes (11) in the active region is grounded individually via a respective one of the source electrode pads (13) connected to the source electrode directly and a respective through hole (4). With this invention, the problems caused by the position arrangement of the through holes in the conventional devices are resolved, while advantages thereof are utilized. Therefore, grounded inductances of source electrodes of the device are minimized, and the performances, such as gain and power, of the device are increased.

## Description

### TECHNICAL FIELD

The present invention relates to semiconductor technology, and more particularly to a semiconductor device having through holes and a manufacturing method thereof.

### BACKGROUND

Compared with the first-generation semiconductor of silicon and the second-generation semiconductor of GaA, the semiconductor material of GaN has many advantages such as large band gap, high electron saturation drift velocity, high breakdown voltage and ability of withstanding high temperatures, which makes it more suitable for electronic devices having high temperature, high pressure, high frequency and high power. Therefore, GaN has broad application prospects and becomes a hot research topic in the field of the semiconductor industry.

A GaN High Electron Mobility Transistor (HEMT) is formed using two-dimensional electron gas at AlGaN/GaN heterojunction and can be applied to a field of high frequency, high voltage and high power. Depletion mode GaN HEMT devices are generally produced using the characteristic of constant opening of a two-dimensional electron gas channel since the two-dimensional electron gas has high mobility and high saturation drift velocity, and thus are appropriate for high frequency applications in the field of wireless communications. During a packaging process of a GaN device, a structure having through holes is generally used to increase a gain of the device and reduce grounded inductance. In this structure, etching is generally performed from a rear side of a substrate which is connected to ground to form through holes which penetrate the substrate and a nitride semiconductor epitaxial layer to a source electrode. And then the through holes are filled with metal so that the source electrode is connected to the grounded rear side of the substrate, and thus the inductance from the source electrode to ground is reduced.

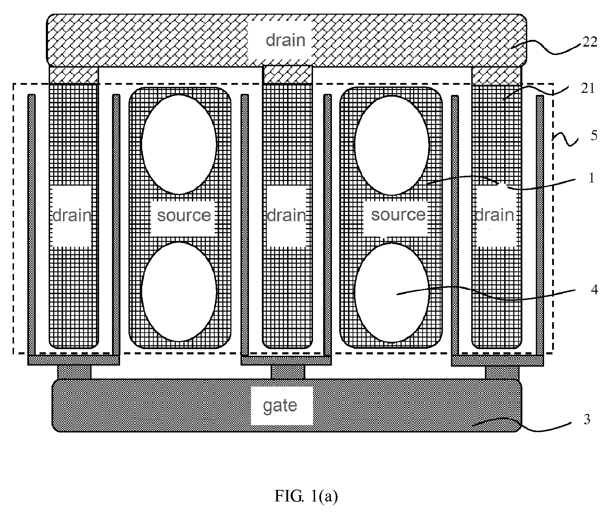

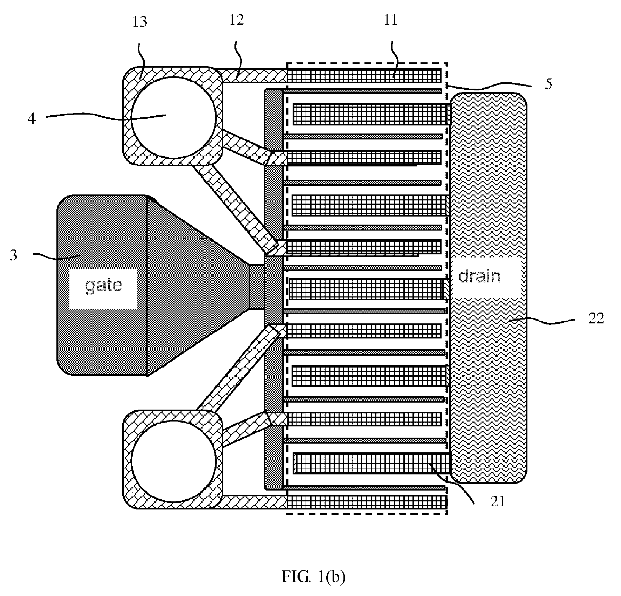

Currently, there are two main arrangements of through holes of GaN devices, as shown in FIGS. 1(a) and 1(b). For example, CREE Company of U.S.A. adopts the arrangement shown in FIG. 1(a), and TriQuint Company of U.S.A. adopts the arrangement shown in FIG. 1(b).

In FIG. 1(a), source electrodes 1 and drain electrodes 21 inside an active region 5 are ohmic contact electrodes, drain electrodes 22 outside the active region 5 are interconnection metals of the ohmic contact drain electrodes 21. Gate electrodes 3 are arranged in an interdigital shape between the source electrodes 1 and the drain electrodes 21. Through holes 4 are disposed in each of the source electrodes 1 inside the active region 5. An area of each of the source electrodes 1 is greater than that of a corresponding one of the drain electrodes 21. An advantage of this arrangement of through holes lies in that each source electrode inside the active region can be grounded directly via the through holes. Thus, distances between the source electrodes inside the active region and the ground are reduced, and the grounded inductances are reduced and are same for each of the source electrodes. However, there are some shortcomings of this arrangement of through holes. Firstly, since the through holes are disposed in the source electrodes inside the active region, the sizes of the through holes are limited. Small through holes will lead to not only high grounded inductances but also complicated manufacturing processes. Secondly, heat dissipation is deteriorated. On the one hand, under the condition that the area of the active region is determined, the area of each of the source electrodes 1 will be increased in order to increase diameters of the through holes, thus the area of the source electrodes 1 will become larger and the area of the drain electrodes 21 will be reduced. Since the distribution of ohmic contact electrodes is not uniform, the heat dissipation of the device is affected. On the other hand, after forming through holes in the source electrodes 1 inside the active region 5, the through holes are hollow, which affects the heat dissipation of the device. Thirdly, the source electrodes 1 are ohmic contacts, and thus are not suitable to be used as an etching barrier layer. Usage of source electrodes 1 which are ohmic contacts as the etching barrier layer will damage contact performance of ohmic contact electrodes and affect barrier effect for etching.

In FIG. 1(b), source electrodes 11 and drain electrodes 21 inside an active region 5 are ohmic contact electrodes, drain electrodes 22 outside the active region 5 are interconnection metals of the ohmic contact drain electrodes 21. Gate electrodes 3 are arranged in an interdigital shape between the source electrodes 11 and the drain electrodes 21. The source electrode interconnections 12 and the source electrode pads 13 outside the active region 5 are interconnection metals of the source electrodes 11. Several source electrodes 11 are connected to a same source electrode pad 13 via corresponding source electrode interconnections 12. The source electrode pads 13 are arranged at both sides of the gate electrodes 3 symmetrically. Through holes 4 are disposed in each of the source electrode pads 13. Such an arrangement of through holes overcomes the shortcomings of FIG. 1(a) in which the through holes are disposed in the source electrodes inside the active region. The through holes are disposed outside the active region, thus the sizes of through holes are not limited, the heat dissipation is not affected, and the selection of etching barrier layers is flexible. However, the arrangement has the shortcomings as follows. Firstly, distances between the source electrodes inside the active region and the ground are increased, which adversely increases the grounded inductance of the source electrodes. Secondly, the source interconnections must cross the gate electrodes and thus air bridges must be used. On the one hand, the presence of air bridges makes the device more complicated, thereby increasing processing difficulty. On the other hand, during the device packaging process, the air bridges are very easy to be collapsed, reducing the reliability of the device. Also, capacitance is introduced between the source electrodes and the gate electrodes due to the air bridges, reducing the high-frequency performance of the device. Thirdly, the source electrode interconnections 12 have different lengths, thus the source electrodes 11 have different grounded inductances, which affects performances, such as gain, of the device.

Accordingly, in view of the technical problems above, there is a demand to propose a semiconductor device having a new through hole arrangement and a manufacturing method thereof.

### SUMMARY

The present invention is directed to a semiconductor device having a new through hole arrangement which is capable of resolving the problems caused by the position arrangement of the through holes in the conventional devices (as shown in FIGS. 1(a) and 1(b)) while utilizing advantages thereof, minimizing grounded inductances of source electrodes of the device, and increasing the performances, such as gain and power, of the device.

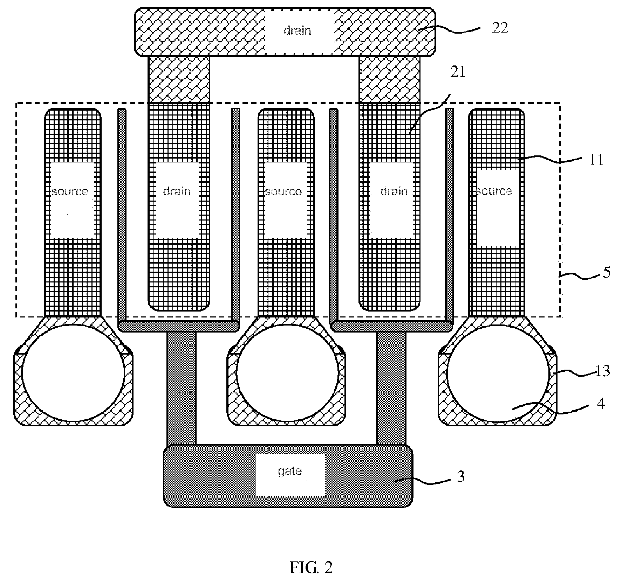

As shown in FIG. 2, in a semiconductor device according to this invention, source electrodes 11 and drain electrodes 21 inside an active region 5 are ohmic contact electrodes, drain electrodes 22 inside an inactive region are interconnection metals of the drain electrodes 21 inside the active region, gate electrodes 3 have an interdigital arrangement between the source electrodes and the drain electrodes, source electrode pads 13 in the inactive region are interconnection metals of the source electrodes 11, the source electrodes 11 have a one-to-one match relationship with the source electrode pads 13, each of the source electrodes 11 is directly connected to a respective one of the source electrode pads 13, the source electrode pads 13 are arranged between the gate electrodes 3 outside the active region 5 symmetrically, and through holes 4 are disposed in each of the source electrode pads 13.

Compared with the position arrangement of through holes of the semiconductor device according to the prior art shown in FIG. 1(a), in the design of the semiconductor device according to the present invention, through holes 4 are disposed in source electrode interconnection metals which are outside the active region and closest to the source electrodes. In the two arrangements, the grounded distances are substantially the same, and the grounded inductances of source electrodes are the same. However, this invention avoids the problems brought by FIG. 1(a). That is, through holes 4 are not directly disposed in the source electrodes 11 in the active region, instead, in source electrode interconnection metals which are outside the active region and close to the source electrodes, i.e., the source electrode pads 13. In this way, the following advantages are obtained.

Firstly, the shapes and number of the through holes 4 and the source electrode pads 13 are not limited, which benefits reduction of grounded inductances and processing difficulty.

Secondly, the sizes of the source electrodes and those of the drain electrodes in the active region may be the same, which resolves the heat dissipation issue due to difference in size and increases an output power of the device.

Thirdly, the problem of using ohmic metals as the etching barrier layer is resolved. The interconnection metals are outside the active region and have broad selection scopes, which benefits the etching process for through holes and does not affect the performances of source electrode ohmic contacts. Thus performances of the device, such as transconductance and power, are increased.

Compared with the position arrangement of through holes of the semiconductor device according to the prior art shown in FIG. 1(b), in the design of the semiconductor device according to the present invention, the same point is that the through holes are disposed in interconnection metals outside the active region, but the different point is that the source electrodes 11 inside the active region are connected to source electrode pads 13 directly, without the use of source electrode interconnections 12, thereby providing the advantages as follows.

Firstly, the source electrodes 11 inside the active region are connected to source electrode pads 13 directly, thus the distances between the source electrodes inside the active region and the ground are decreased, thereby decreasing the grounded inductances.

Secondly, there are no source electrode interconnections 12, the source electrodes do not need to cross the gate electrodes, thus air bridges crossing the gate electrodes are not required, which reduces the processing difficulty and improves the reliability and high frequency property of the device.

Thirdly, there are no source electrode interconnections 12, the problem of grounded inductances of source electrodes 11 being different which is caused by different lengths of source electrode interconnections 12 is avoided, thereby improving the performances, such as gain, of the device.

In order to achieve the above-mentioned objects, embodiments of the present invention provide the technical schemes as follows.

A semiconductor device, the semiconductor device comprising:
a substrate, a grounded electrode being disposed on a bottom surface of the substrate;
a semiconductor layer located on an upper surface of the substrate, the semiconductor layer including an active region and an inactive region, the active region being in an enclosed form and the inactive region being outside the active region;
source electrodes and drain electrodes disposed in the active region and drain electrodes disposed in the inactive region, the source electrodes and the drain electrodes in the active region being ohmic contact electrodes, there being a plurality of ohmic contact electrodes, each ohmic contact electrode having a same size, each pair of adjacent ohmic contact electrodes having a same interval, the drain electrodes in the inactive region being interconnection metals of the drain electrodes in the active region;
gate electrodes in the active region and the inactive region, the gate electrodes in the active region having an interdigital arrangement between the source electrodes and the drain electrodes, the gate electrodes in the inactive region being interconnection metals of the gate electrodes in the active region;
source electrode pads disposed in the inactive region, the source electrode pads being directly electrically connected to the source electrodes in the active region, the source electrode pads being arranged between the gate electrodes or at both sides of the gate electrodes symmetrically;
through holes disposed between the grounded electrode and the source electrode pads, the through holes penetrating the semiconductor layer and the substrate and reaching the source electrode pads, the through holes electrically connecting the source electrode pads and the grounded electrode disposed on the bottom surface of the substrate,
wherein each of the source electrodes in the active region is grounded individually via a respective one of the source electrode pads connected to the source electrode directly and a respective one of the through holes.

As a further improvement of this invention, each of the source electrodes in the active region is directly connected to one or more than one source electrode pads.

As a further improvement of this invention, the source electrode pads are disposed at a same side of the active region and/or the source electrode pads are disposed at different sides of the active region.

As a further improvement of this invention, each of the source electrode pads is connected with one or more than one through holes.

As a further improvement of this invention, the source electrode pads corresponding to the source electrodes in the active region have the same or different cross-sectional shapes.

As a further improvement of this invention, the cross-sections of the source electrode pads have regular or irregular shapes.

As a further improvement of this invention, the cross-sections of the through holes have regular or irregular shapes.

As a further improvement of this invention, the semiconductor layer includes a material selected from a group constituting of gallium nitride, aluminum gallium nitride, indium gallium nitride, indium aluminum gallium nitride, gallium arsenide, indium phosphide or a combination thereof.

Correspondingly, a method of manufacturing a semiconductor device, the method comprising the steps of:
S1. preparing a substrate, a grounded electrode being disposed on a bottom surface of the substrate;
S2. depositing a semiconductor layer on an upper surface of the substrate, the semiconductor layer including an active region and an inactive region, the active region being in an enclosed form and the inactive region being outside the active region;
S3. forming source electrodes in the active region, forming drain electrodes in the active region and drain electrodes in the inactive region, the source electrodes and the drain electrodes in the active region being ohmic contact electrodes, there being a plurality of ohmic contact electrodes, each ohmic contact electrode having a same size, each pair of adjacent ohmic contact electrodes having a same interval, the drain electrodes in the inactive region being interconnection metals of the drain electrodes in the active region;
S4. forming gate electrodes in the active region and the inactive region, the gate electrodes in the active region having an interdigital arrangement between the source electrodes and the drain electrodes, the gate electrodes in the inactive region being interconnection metals of the gate electrodes in the active region;
S5. forming source electrode pads in the inactive region, the source electrode pads being directly electrically connected to the source electrodes in the active region, the source electrode pads being arranged between the gate electrodes or at both sides of the gate electrodes symmetrically;
S6. forming through holes having electrical conductivity between the grounded electrode and the source electrode pads, the through holes penetrating the substrate and the semiconductor layer and reaching the source electrode pads, the through holes electrically connecting the source electrode pads and the grounded electrode disposed on the bottom surface of the substrate, each of the source electrodes in the active region being grounded individually via a respective one of the source electrode pads connected to the source electrode directly and a respective one of the through holes.

With the semiconductor device and the manufacturing method thereof according to the present invention, the problems caused by the position arrangement of the through holes in the conventional devices are resolved, while advantages thereof are utilized. Therefore, grounded inductances of source electrodes of the device are minimized, and the performances, such as gain, of the device are increased.

### BRIEF DESCRIPTION OF DRAWINGS

In order to illustrate embodiments of the present invention or the prior art more clearly, hereinafter a simple introduction is made to the accompanying drawings used in the description of the embodiments or the prior art. It is obvious for those skilled in the art that the accompanying drawings just illustrate some embodiments of the present invention, and other accompanying drawings can be obtained based on the current accompanying drawings without inventive work. In the drawings:
FIG. 1(a) is a schematic structural view illustrating arrangement of positions of through holes in a GaN device according to the prior art;
FIG. 1(b) is a schematic structural view illustrating arrangement of positions of through holes in another GaN device according to the prior art;
FIG. 2 is a schematic top view illustrating a structure of a semiconductor device according to a first embodiment of the present invention;
FIG. 3 is a schematic top view illustrating a structure of a semiconductor device according to a second embodiment of the present invention;
FIG. 4 is a schematic top view illustrating a structure of a semiconductor device according to a third embodiment of the present invention;
FIG. 5 is a schematic top view illustrating a structure of a semiconductor device according to a fourth embodiment of the present invention;
FIG. 6 is a schematic top view illustrating a structure of a semiconductor device according to a fifth embodiment of the present invention;
FIG. 7 is a schematic top view illustrating a structure of a semiconductor device according to a sixth embodiment of the present invention;
FIG. 8 is a schematic top view illustrating a structure of a semiconductor device according to a seventh embodiment of the present invention;
FIG. 9 is a schematic top view illustrating a structure of a semiconductor device according to an eighth embodiment of the present invention.

### DETAILED DESCRIPTION

The present invention will be described in detail hereinafter with reference to the specific embodiments in conjunction with the accompanying drawings. However, the present invention is not limited to the embodiments, rather, any modification of structures, methods or functions by those skilled in the art based on these embodiments is included within the scope of this invention.

In addition, like reference numerals may be used in different embodiments. Such a repeat is just for simple and clear description of the present invention, and does not imply that there is any correlation between the different embodiments and/or structures.

### The first embodiment

As shown in FIG. 2, in the first embodiment of the present invention, a semiconductor device comprises:
a substrate, wherein a grounded electrode is disposed on a bottom surface of the substrate;
a semiconductor layer located on an upper surface of the substrate, wherein the semiconductor layer includes an active region 5 which is in an enclosed form and an inactive region which is outside the active region 5;
source electrodes 11 and drain electrodes 21 disposed in the active region and drain electrodes 22 disposed in the inactive region, wherein the source electrodes 11 and the drain electrodes 21 in the active region are ohmic contact electrodes, there are a plurality of ohmic contact electrodes, each ohmic contact electrode has a same size, each pair of adjacent ohmic contact electrodes have a same interval, the drain electrodes 22 in the inactive region are interconnection metals of the drain electrodes 21 in the active region;
gate electrodes 3 in the active region and the inactive region, wherein the gate electrodes 3 in the active region 5 have an interdigital arrangement between the source electrodes 11 and the drain electrodes 21, the gate electrodes 3 in the inactive region are interconnection metals of the gate electrodes in the active region;
source electrode pads 13 disposed in the inactive region, wherein the source electrode pads 13 are directly electrically connected to the source electrodes 11 in the active region 5, the source electrode pads 13 are arranged between the gate electrodes 3 or at both sides of the gate electrodes 3 symmetrically;
through holes 4 disposed between the grounded electrode and the source electrode pads 13, wherein the through holes 4 penetrate the substrate and the semiconductor layer and reach the source electrode pads 13, so as to electrically connect the source electrode pads 13 and the grounded electrode disposed on the bottom surface of the substrate, each of the source electrodes 11 in the active region 5 is grounded individually via a respective source electrode pad 13 connected to the source electrode 11 directly and a respective through hole 4.

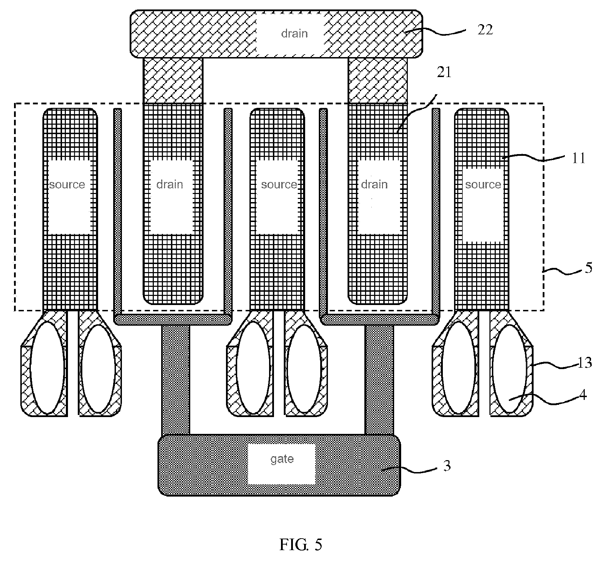

It should be noted that each source electrode pad 13 may comprise at least one sub source electrode pad. The sub source electrode pad has the same structure as the source electrode pads. When each source electrode pad 13 comprises a plurality of sub source electrode pads, a structure of the semiconductor device is shown in FIG. 5 and will be described with reference to a sixth embodiment.

In addition, the above-described source electrode pads 13 are arranged between the gate electrodes or at both sides of the gate electrodes. Specifically, the source electrode pads 13 may be located at a same side of the active region 5, as shown in FIG. 2, alternatively, they may be located at different sides of the active region 5, as shown in FIG. 5 and the sixth embodiment.

Further, the semiconductor layer includes any material selected from a group constituting of gallium nitride, aluminum gallium nitride, indium gallium nitride, indium aluminum gallium nitride, gallium arsenide, indium phosphide or a combination thereof.

Cross-sections of the source electrode pads 13 may have regular shapes or irregular shapes. Cross-sections of the through holes 4 may have regular shapes or irregular shapes. For example, in this embodiment, the cross-sections of the source electrode pads have a shape of a combination of an isosceles trapezoid and a rectangle, while the cross-sections of the through holes are circular.

Correspondingly, a manufacturing method of the above-described semiconductor device specifically includes:
S1. preparing a substrate, wherein a grounded electrode is disposed on a bottom surface of the substrate;
S2. depositing a semiconductor layer on an upper surface of the substrate, wherein the semiconductor layer includes an active region 5 which is in an enclosed form and an inactive region which is outside the active region 5;
S3. forming source electrodes 11 in the active region 5, forming drain electrodes 21 in the active region 5 and in the inactive region, wherein the source electrodes 11 and the drain electrodes 21 in the active region are ohmic contact electrodes, there are a plurality of ohmic contact electrodes, each ohmic contact electrode has a same size, each pair of adjacent ohmic contact electrodes have a same interval, the drain electrodes 22 in the inactive region are interconnection metals of the drain electrodes 21 in the active region;
S4. forming gate electrodes 3 in the active region and the inactive region, wherein the gate electrodes 3 in the active region have an interdigital arrangement between the source electrodes 11 and the drain electrodes 21, the gate electrodes 3 in the inactive region are interconnection metals of the gate electrodes in the active region;
S5. forming source electrode pads 13 in the inactive region, wherein the source electrode pads 13 are directly electrically connected to the source electrodes 11 in the active region 5, the source electrode pads 13 are arranged between the gate electrodes or at both sides of the gate electrodes symmetrically; cross-sections of the source electrode pads may have regular shapes or irregular shapes, for example, the cross-sections of the source electrode pads may have a shape of a combination of an isosceles trapezoid and a rectangle;
S6. forming through holes 4 having electrical conductivity between the grounded electrode and the source electrode pads, wherein the through holes 4 penetrate the substrate and the semiconductor layer and reach the source electrode pads 13, so as to electrically connect the source electrode pads 13 and the grounded electrode disposed on the bottom surface of the substrate, each of the source electrodes 11 in the active region 5 is grounded individually via a respective source electrode pad 13 connected to the source electrode 11 directly and a respective through hole 4; cross-sections of the through holes 4 may have regular shapes such as circular shapes or irregular shapes.

This embodiment resolves the problems caused by the position distribution of the through holes in the conventional devices, meanwhile utilizes the advantages thereof, thereby minimizing the grounded inductances of the source electrodes in the devices and increasing performances, such as gain, of the devices.

### The second embodiment

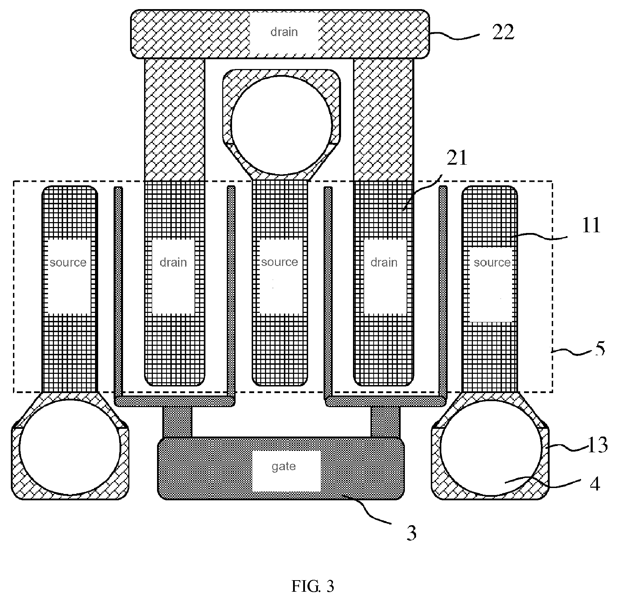

FIG. 3 is a schematic top view illustrating a structure of a semiconductor device according to the second embodiment of the present invention. Different from the first embodiment, in this embodiment, the source electrode pads 13 are disposed at different sides of the active region 5. Here, one source electrode pad 13 is disposed at one side of the active region 5, while another source electrode pad 13 is disposed at the other side of the active region 5. However, no matter which side the source electrode pads 13 are disposed, the source electrode pads 13 are arranged between the gate electrodes or at both sides of the gate electrodes symmetrically. Moreover, the source electrode pads 13 are directly electrically connected to the source electrodes in the active region 5.

Such a structure increases the flexibility of design. Other aspects of structure and manufacturing method are the same or substantially the same as those according to the first embodiment, thus repeated descriptions are omitted.

### The third embodiment

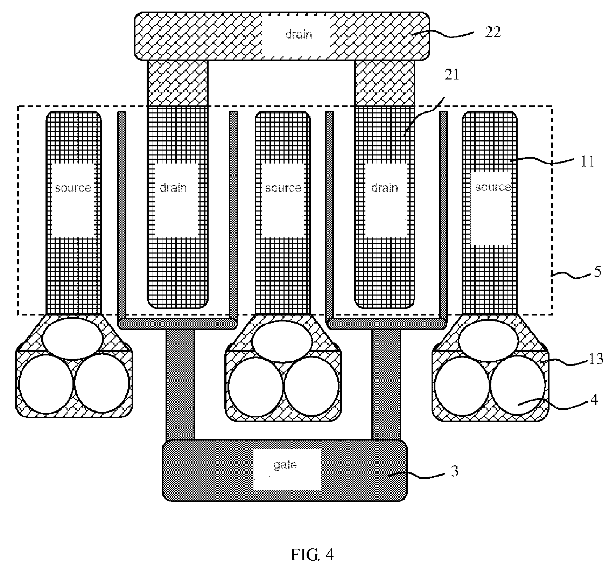

FIG. 4 is a schematic top view illustrating a structure of a semiconductor device according to the third embodiment of the present invention. Different from the first embodiment, in this embodiment, three through holes 4 are connected to each of the source electrode pads 13. The cross-sections of the through holes have circular shapes or other shapes. It can be understood that another number, other than three, of through holes can be provided in other embodiments. Such a structure increases areas of cross-sections of through holes, which will benefit reduction of ground inductances. Other aspects of structure and manufacturing method are the same or substantially the same as those according to the first embodiment, thus repeated descriptions are omitted.

### The fourth embodiment

FIG. 5 is a schematic top view illustrating a structure of a semiconductor device according to the fourth embodiment of the present invention. Different from the first embodiment, in this embodiment, each of the source electrode pads 13 includes two sub source electrode pads. The advantages of this embodiment include that utilization of the inactive region can be maximized, and the entire size of the semiconductor device can be reduced. It should be noted that the number of the sub source electrode pads is not limited to two, instead, more than two sub source electrode pads may be included. Similarly, the number of through holes 4 connected to each of the source electrode pads 13 is not limited to one, a plurality of through holes can be provided, similar to the third embodiment. Other aspects of structure and manufacturing method are the same or substantially the same as those according to the first embodiment, thus repeated descriptions are omitted.

### The fifth embodiment

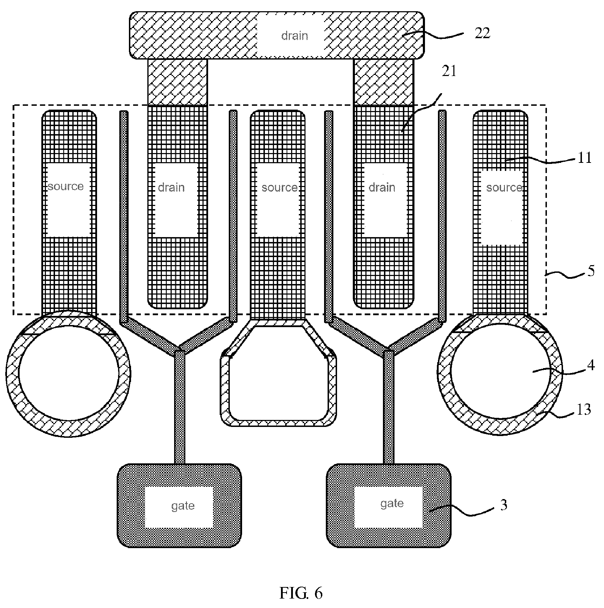

FIG. 6 is a schematic top view illustrating a structure of a semiconductor device according to the fifth embodiment of the present invention. Different from the first embodiment, in this embodiment, the source electrode pads 13 connected to the source electrodes in the active region have different shapes, and correspondingly the through holes 4 have different shapes. The advantages of this embodiment include that utilization of the inactive region can be maximized based on the structures of the gate electrode interconnections, and the entire size of the semiconductor device can be reduced. Other aspects of structure and manufacturing method are the same or substantially the same as those according to the first embodiment, thus repeated descriptions are omitted.

### The sixth embodiment

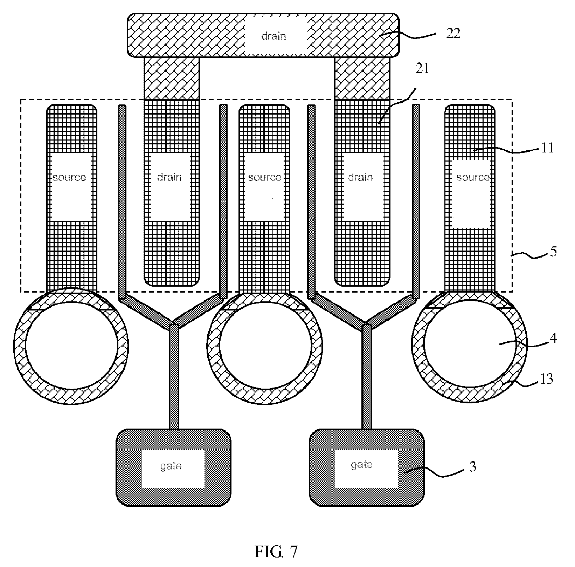

FIG. 7 is a schematic top view illustrating a structure of a semiconductor device according to the sixth embodiment of the present invention. Different from the first embodiment, in this embodiment, all of the cross-sections of the source electrode pads 13 have circular shapes or elliptical shapes, and all of the cross-sections of the through holes 4 have circular shapes or elliptical shapes also. Other aspects of structure and manufacturing method are the same or substantially the same as those according to the first embodiment, thus repeated descriptions are omitted.

### The seventh embodiment

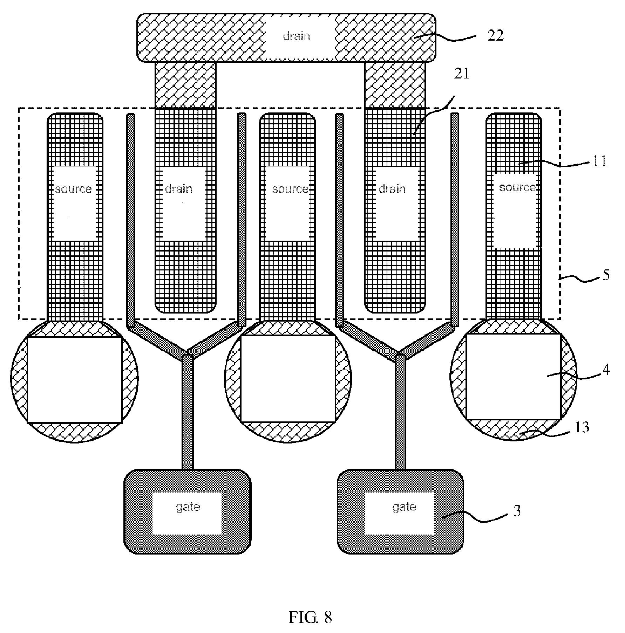

FIG. 8 is a schematic top view illustrating a structure of a semiconductor device according to the seventh embodiment of the present invention. Different from the first embodiment, in this embodiment, all of the cross-sections of the source electrode pads 13 have circular shapes or elliptical shapes, and all of the cross-sections of the through holes 4 have rectangular shapes. Other aspects of structure and manufacturing method are the same or substantially the same as those according to the first embodiment, thus repeated descriptions are omitted.

### The eighth embodiment

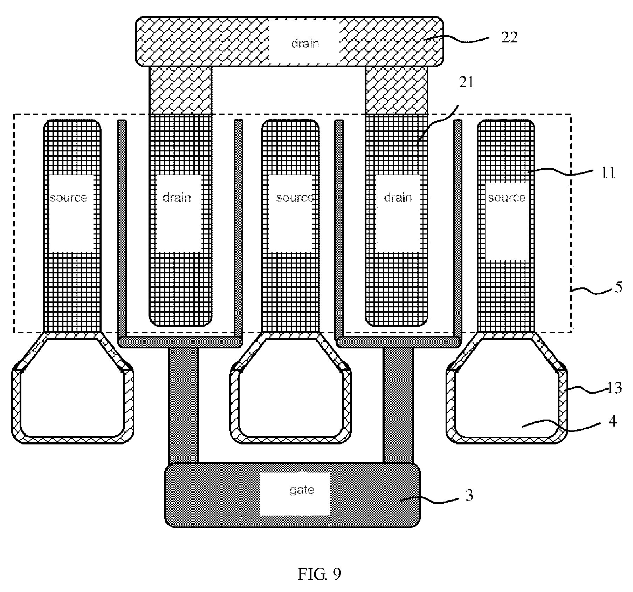

FIG. 9 is a schematic top view illustrating a structure of a semiconductor device according to the eighth embodiment of the present invention. Different from the first embodiment, in this embodiment, the cross-sections of the source electrode pads 13 have irregular shapes, and the cross-sections of the through holes 4 have irregular shapes also. The advantages of using such irregular shapes include maximizing cross-sectional areas of through holes connected to the source electrode pads. Increase of cross-sectional areas of through holes will benefit reduction of grounded inductances. Other aspects of structure and manufacturing method are the same or substantially the same as those according to the first embodiment, thus repeated descriptions are omitted.

Compared with the position arrangement of through holes of the semiconductor device according to the prior art shown in FIG. 1(a), in the design of the semiconductor device according to the present invention, through holes 4 are disposed in source electrode interconnection metals which are outside the active region and closest to the source electrodes. In the two arrangements, the grounded distances are substantially the same, and the grounded inductances of source electrodes are the same. However, this invention avoids the problems brought by FIG. 1(a). That is, through holes 4 are not directly disposed in the source electrodes 11 in the active region, instead, in source electrode interconnection metals which are outside the active region and close to the source electrodes, i.e., the source electrode pads 13. In this way, the following advantages are obtained.

Firstly, the shapes and number of the through holes 4 and the source electrode pads 13 are not limited, which benefits reduction of grounded inductances and processing difficulty.

Secondly, the sizes of the source electrodes and those of the drain electrodes in the active region may be the same, which resolves the heat dissipation issue due to difference in size and increases an output power of the device.

Thirdly, the problem of using ohmic metals as the etching barrier layer is resolved. The interconnection metals are outside the active region and have broad selection scopes, which benefits the etching process for through holes and does not affect the performances of source electrode ohmic contacts. Thus performances of the device, such as transconductance and power, are increased.

Compared with the position arrangement of through holes of the semiconductor device according to the prior art shown in FIG. 1(b), in the design of the semiconductor device according to the present invention, the same point is that the through holes are disposed in interconnection metals outside the active region, but the different point is that the source electrodes 11 inside the active region are connected to source electrode pads 13 directly, without the use of source electrode interconnections 12, thereby providing the advantages as follows.

Firstly, the source electrodes 11 inside the active region are connected to source electrode pads 13 directly, thus the distances between the source electrodes inside the active region and the ground are decreased, thereby decreasing the grounded inductances.

Secondly, there are no source electrode interconnections 12, the source electrodes do not need to cross the gate electrodes, thus air bridges crossing the gate electrodes are not required, which reduces the processing difficulty and improves the reliability and high frequency property of the device.

Thirdly, there are no source electrode interconnections 12, the problem of grounded inductances of source electrodes 11 being different which is caused by different lengths of source electrode interconnections 12 is avoided, thereby improving the performances, such as gain, of the device.

It can be seen from the above embodiments, with the semiconductor device and the manufacturing method thereof according to the present invention, the problems caused by the position arrangement of the through holes in the conventional devices are resolved, while advantages thereof are utilized. Therefore, grounded inductances of source electrodes of the device are minimized, and the performances, such as gain, of the device are increased.

It will be understood by those skilled in the art that the present invention is not limited to the exemplary embodiments, rather, this invention may be realized in other specific forms without departing from the spirit or features of the present invention. Therefore, the embodiments should be considered as exemplary, not limitative. The scope of the present invention is defined by the appended claims rather than the foregoing description. This invention is intended to cover all modifications included within the spirit and scope of the appended claims and the equivalent arrangements. Any reference numeral in the claims should not be considered as limitation to the claims.

Further, it will be understood that although various embodiments are described in the specification, it does not mean that each embodiment contains only one separate technical scheme. This description manner is just for clarity, the specification should be considered as a whole by those skilled in the art. The technical schemes in various embodiments may be combined to form other embodiments understood by those skilled in the art.

## Claims

1. A semiconductor device, **characterized in that** the semiconductor device comprises:
a substrate, a grounded electrode being disposed on a bottom surface of the substrate;
a semiconductor layer located on an upper surface of the substrate, the semiconductor layer including an active region and an inactive region, the active region being in an enclosed form and the inactive region being outside the active region;
source electrodes and drain electrodes disposed in the active region and drain electrodes disposed in the inactive region, the source electrodes and the drain electrodes in the active region being ohmic contact electrodes, there being a plurality of ohmic contact electrodes, each ohmic contact electrode having a same size, each pair of adjacent ohmic contact electrodes having a same interval, the drain electrodes in the inactive region being interconnection metals of the drain electrodes in the active region;
gate electrodes in the active region and the inactive region, the gate electrodes in the active region having an interdigital arrangement between the source electrodes and the drain electrodes, the gate electrodes in the inactive region being interconnection metals of the gate electrodes in the active region;
source electrode pads disposed in the inactive region, the source electrode pads being directly electrically connected to the source electrodes in the active region, the source electrode pads 13 being arranged between the gate electrodes or at both sides of the gate electrodes symmetrically;
through holes disposed between the grounded electrode and the source electrode pads, the through holes penetrating the semiconductor layer and the substrate and reaching the source electrode pads, the through holes electrically connecting the source electrode pads and the grounded electrode disposed on the bottom surface of the substrate,
wherein each of the source electrodes in the active region is grounded individually via a respective one of the source electrode pads connected to the source electrode directly and a respective one of the through holes.

2. The semiconductor device of claim 1, wherein the source electrode pads comprise at least one sub source electrode pad.

3. The semiconductor device of claim 1, wherein the source electrode pads are disposed at a same side of the active region and/or the source electrode pads are disposed at different sides of the active region.

4. The semiconductor device of claim 2, wherein each of the sub source electrode pads is connected with one or more than one through holes.

5. The semiconductor device of claim 1, wherein the source electrode pads corresponding to the source electrodes in the active region have the same or different cross-sectional shapes.

6. The semiconductor device of claim 1, wherein the cross-sections of the source electrode pads have regular or irregular shapes.

7. The semiconductor device of claim 1, wherein the cross-sections of the through holes have regular or irregular shapes.

8. The semiconductor device of claim 1, wherein the semiconductor layer includes a material selected from a group constituting of gallium nitride, aluminum gallium nitride, indium gallium nitride, indium aluminum gallium nitride, gallium arsenide, indium phosphide or a combination thereof.

9. A method of manufacturing a semiconductor device according to any one of claims 1-8, **characterized in that** the method comprises the steps of:
S1. preparing a substrate, a grounded electrode being disposed on a bottom surface of the substrate;
S2. depositing a semiconductor layer on an upper surface of the substrate, the semiconductor layer including an active region and an inactive region, the active region being in an enclosed form and the inactive region being outside the active region;
S3. forming source electrodes in the active region, forming drain electrodes in the active region and drain electrodes the inactive region, the source electrodes and the drain electrodes in the active region being ohmic contact electrodes, there being a plurality of ohmic contact electrodes, each ohmic contact electrode having a same size, each pair of adjacent ohmic contact electrodes having a same interval, the drain electrodes in the inactive region being interconnection metals of the drain electrodes in the active region;
S4. forming gate electrodes in the active region and the inactive region, the gate electrodes in the active region having an interdigital arrangement between the source electrodes and the drain electrodes, the gate electrodes in the inactive region being interconnection metals of the gate electrodes in the active region;
S5. forming source electrode pads in the inactive region, the source electrode pads being directly electrically connected to the source electrodes in the active region, the source electrode pads being arranged between the gate electrodes or at both sides of the gate electrodes symmetrically;
S6. forming through holes having electrical conductivity between the grounded electrode and the source electrode pads, the through holes penetrating the substrate and the semiconductor layer and reaching the source electrode pads, the through holes electrically connecting the source electrode pads and the grounded electrode disposed on the bottom surface of the substrate, each of the source electrodes in the active region being grounded individually via a respective one of the source electrode pads connected to the source electrode directly and a respective one of the through holes.
